# EUROPEAN PATENT SPECIFICATION

(11) **EP 2 705 575 B1**
(45) Date of publication and mention of the grant of the patent: **12.04.2017**
(21) Application number: 12779900.5
(22) Date of filing: 03.05.2012
(51) Int. Cl.: H01R 12/51, H05K 1/18, H01R 13/04, H05K 3/34, H01R 107/00, H01R 12/72, H01R 13/53, H01R 12/71

(54) **HIGH-VOLTAGE RESISTANCE FOR A CONNECTOR ATTACHED TO A CIRCUIT BOARD**
HOCHSPANNUNGSWIDERSTAND FÜR EINEN AN EINER LEITERPLATTE BEFESTIGTEN VERBINDER
RÉSISTANCE À HAUTE TENSION POUR UN CONNECTEUR FIXÉ À UNE CARTE DE CIRCUIT IMPRIMÉ

(30) Priority: 03.05.2011 US 201161481855 P
(43) Date of publication of application: 12.03.2014
(73) Proprietor: CardioInsight Technologies, Inc., Independence, OH 44131 (US)
(72) Inventor: VENALECK, John T., Painesville, Ohio 44077 (US); CROFOOT, Larry M., Perry, Ohio 44077 (US)
(74) Representative: Schmidt, Steffen J.
(86) International application number: PCT/US2012/036271
(87) International publication number: WO 2012/151371

(56) References cited:
- EP-A2- 1 289 070
- EP-A2- 1 515 398
- EP-A2- 1 953 871
- WO-A1-2004/100318
- WO-A2-2009/099926
- WO-A2-2009/099926
- JP-A- 2000 294 321
- JP-A- 2009 070 988
- US-A- 4 695 112

## Description

### BACKGROUND

Printed circuit boards often have electrical connectors attached at one edge by soldering the tails of the connector to pads provided at the edge of the board. The distance between adjacent tails and between adjacent pads is often small and will not sustain high voltage without current leakage or voltage breakdown. It is desirable to provide a connector design that allows soldered connection to the edge of a circuit board that is resistant to current leakage and voltage breakdown when a high voltage appears between the pads.

Document WO 2004/100318 A1 discloses a contact assembly for supplying an operating alternating voltage that has been generated from a direct current voltage by a supply circuit to an electroluminescent illumination assembly. Said assembly comprises at least one planar capacitor, which is mounted on one surface of a carrier plate and has a base electrode, an insulation layer, a pigment layer that is luminous during operation and a transparent, electrically insulating top electrode, in addition to a transparent, electrically insulating protective layer that covers the planar capacitor. On one surface of the carrier plate, the contact assembly is equipped with at least two adjacent electrically conductive contact surfaces that are not covered by the electrically insulating protective layer, one of which has an electrically conductive connection to the base electrode and the other an electrically conductive connection to the top electrode of the planar capacitor or capacitors, in addition to a plug element on the carrier plate side, said element having a body consisting of an insulation material, at least two electrically conductive contact elements and at least two electrically conductive plug-in connection elements. The plug element is mounted on the carrier plate of the electroluminescent illumination assembly in such a way that one respective contact element forms an electric contact with one of the contact surfaces of the electroluminescent illumination assembly and its body covers the contact elements and the contact surfaces in a contact-proof manner.

Document WO 2009/099926 A2 discloses an RF connector including an RF connector block including a body portion having a plurality of dividers projecting from a surface thereof with each of the dividers having a first surface configured to mate with an RF circuit board and having a second sloped surface. The RF connector block also includes a plurality of signal contacts disposed between each of the plurality of dividers with a first portion of each of the plurality of signal contacts disposed to mate with the RF circuit board and a second portion of each of the signal contacts disposed through an opposite side of the RF connector block. A plurality of RF connector receptacles are configured to mate with the second portion of a corresponding one of said plurality of signal connectors. Such an arrangement results in an RF connector having signal contacts highly isolated from each other.

Document EP 1 515 398 A2 discloses a connector that is electrically connecting to a memory card which includes a card main body having a plurality of grooves formed on a distal end side thereof and connection terminals disposed on a bottom surface of the grooves of the card main body. The connector includes a housing having a plurality of extension portions fitting to the grooves of the card main body, contacts held by the extension portions of the housing. Each extension portions of the housing has a through-hole. The contact has a base portion fixed by the through-hole, and an elastic portion extending from the fixed portion to the groove and capable of undergoing elastic deformation. The surface of the extension portion of the housing and the surface of the memory card exist substantially on the same level when the grooves of the memory card are fitted to the extension portions of the housing.

Document EP 1 289 070 A2 discloses a pair of mating connectors including a receptacle having an insulative housing and at least one conductive receptacle contact with a pair of spaced walls forming a plug contact receiving space. The plug connector has an insulative housing and at least one conductive contact having a pair of spaced walls, which converge to form a projection engageable in the plug receiving space of the receptacle contact. In each case, the spaced walls are joined by a bridging structure that unites the walls. The plug and receptacle contacts are retained in the respective housings by engagement of opposed lateral edge portions of the contacts with the housings in a manner to enhance heat dissipation by convection by maintaining substantial portions of the contacts spaced from the housing walls and from each other. The bridging structure may include a retention element for engaging respective connector housings to retain the contact in the housings. The open structure of both the receptacle and plug contacts enhances heat dissipation and allows flexibility in achieving desired contact normal forces.

Document US 4 695 112 describes retention of terminals in an edgeboard connector for connecting wires to a printed circuit board is affected using a variety of structural elements. Lances depending from the front end of each terminal are inserted in slots in the bottom wall of the connector; stop-blocks on the interior of the connector are used to orient and retain the terminals in position within the connector housing and a lock bar is fixedly attached to a rear portion of the connector so as to abut against ears disposed on a sidewall of the terminal so as to simultaneously hold in place the entire array of terminals in the connector.

### SUMMARY OF THE INVENTION

According to one aspect of the invention, rectangular pads are provided on the surface along one edge of a circuit board. These pads are in close array and do not extend to the edge of the board. The pads extend into the board a finite distance.

According to another aspect of the invention, pads on the edge of a circuit board have vias located centrally to provide electrical communication with layers of circuits within the board, not on the surface.

According to yet another aspect of the invention, rectangular slots in the circuit board are provided between the pads and extend from the edge of the board inwardly beyond the depth of the pads.

According to an aspect of this invention, a connector has ribs between output tails that extend some finite distance beyond the tails.

According to another aspect of the invention, ribs between contact tails of a connector fit into slots provided in a printed circuit board.

According to another aspect of the invention, the tails of the connector fit the pads of the circuit board and are soldered therein.

According to another aspect of the invention, the combination of ribs and slots provide an extended isolation path preventing current leakage and voltage breakdown.

According to yet another aspect of the invention, a combination of a circuit board and a connector mounted on an edge of the circuit board, may include one or more of the following features: the circuit board has contact pads away from the edge; the contact pads are on individual circuit board fingers; slots, such as rectangular slots, are between adjacent circuit board fingers; the slots have a depth that extends further from the edge than do the contact pads; the contact pads have respective conductive vias that electrically connect the conductive pads to circuitry of the circuit board; the circuitry is within (inside) the circuit board, as opposed to being on a surface of the circuit board; the connector has ribs alternating with contact tails that are configured to engage the contact pads; the ribs are parts of a plastic connector body of the connector; the connector body is a single molded plastic piece; the ribs enter the slots when the connector is coupled to the circuit board; the ribs are between adjacent contact pads, extending the isolation path between the adjacent contact pads; and the combination of the ribs and the slots provides an extended isolation path preventing current leakage and voltage breakdown.

According to another aspect of the invention, a device includes: a circuit board; and a connector mounted on an edge of the circuit board. The circuit board has contact pads away from an edge of the circuit board that is closet to the connector. The connector has the connector has ribs alternating with contact tail. The contact tails engage the contact pads.

According to yet another aspect of the invention, a circuit board includes: circuit board fingers with slots therebetween; and contact pads, away from an edge of the circuit board, on the circuit board fingers.

To the accomplishment of the foregoing and related ends, the invention comprises the features hereinafter fully described and particularly pointed out in the claims. The following description and the annexed drawings set forth in detail certain illustrative embodiments of the invention. These embodiments are indicative, however, of but a few of the various ways in which the principles of the invention may be employed. Other objects, advantages and novel features of the invention will become apparent from the following detailed description of the invention when considered in conjunction with the drawings.

### BRIEF DESCRIPTION OF THE DRAWINGS

The annexed drawings, which are not necessarily to scale, show various features of the invention.
Fig. 1 is an exploded view of a device according to an embodiment of the present invention.
Fig. 2 is an oblique view of a connector of the device of Fig. 1.
Fig. 3 is an exploded plan view of portions of the device of Fig. 1.
Fig. 4 is a plan view of the portions of Fig. 3, coupled together.
Fig. 5 is a magnified view of part of the portions shown in Fig. 3.

### DETAILED DESCRIPTION

A circuit board connector is disclosed that has isolator ribs between contact tails, and slots in the edge of a circuit board between circuit pads that communicate with the ribs to avoid pad-to-pad current leakage and high-voltage breakdown. The slots may be between individual circuit board fingers that each include one of the conductor pads.

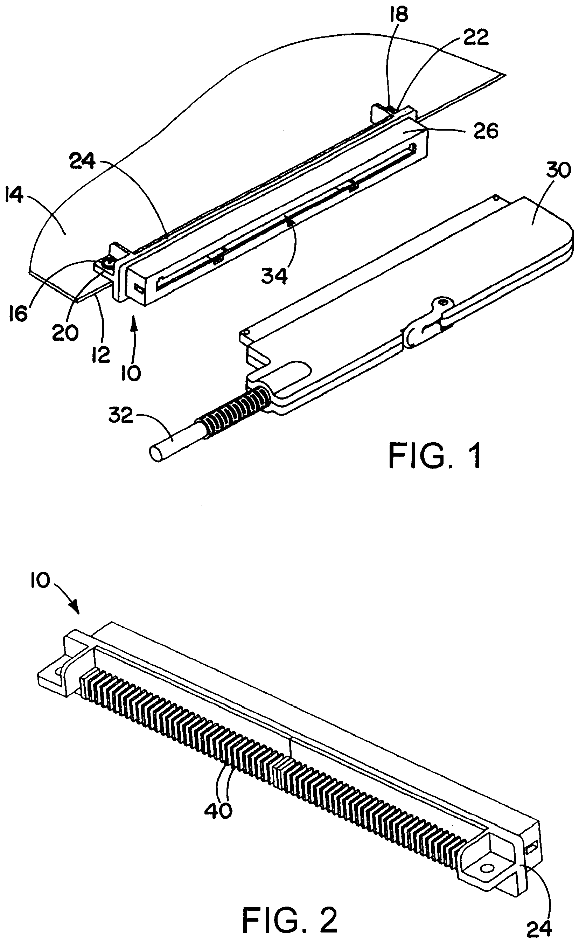

Fig. 1 shows a device that includes a connector 10 that is coupled to an edge 12 of a circuit board 14. The connector 10 has contacts for engaging conductive pads on the circuit board 14, as described in greater detail below. The connector 10 is mechanically coupled to the circuit board by screws 16 and 18 that pass through tabs 20 and 22 of the connector 10. The tabs 20 and 22 are parts of a connector plastic body 24, which may be formed as a single molded piece, and may be made of a suitable plastic that is resistant to high temperatures, such as those produced by soldering. The front of the connector body 24 may be covered by a plastic shroud 26.

The connector 10 is engaged by a mating connector or plug 30. Conductors in a cable 32 are attached to contacts within the plug 30. When the plug 30 is inserted into a receptacle or opening 34 in the connector 10, the contacts of the plug 30 are electrically connected to the contacts of the connector 10.

Fig. 2 shows the back of the connector 10, the part of the connector 10 that engages the circuit board 14 (Fig. 1). Ribs 40 are between circuit-board-engaging contact tails or ends of the connector 10. The ribs 40 are made of a dielectric material, and may be parts of the molded plastic connector body 24.

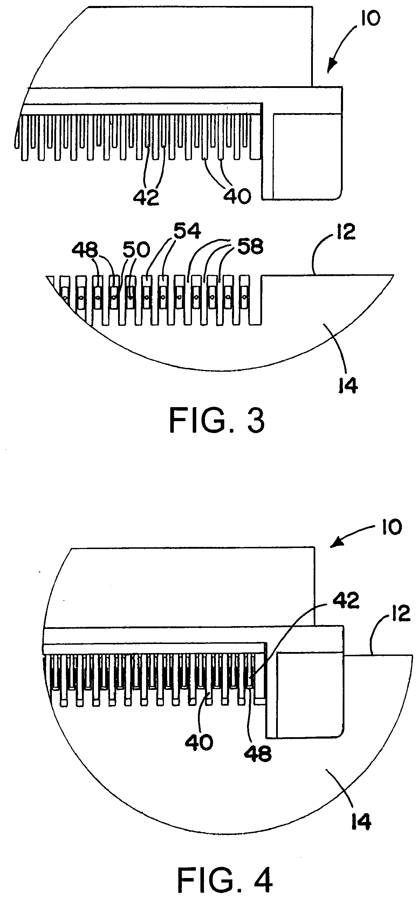

Fig. 3 shows the back of the connector 10 positioned near the edge 12 of the circuit board 14. The ribs 40 of the connector 10 are interspersed between the contact tails or ends 42. The ribs 40 and the contacts tails 42 alternate, with one of the ribs 40 located between each adjacent pair of the tails 42.

The circuit board 14 has contact pads 48 that are used to engage the tails 42 when the connector 10 is installed on the circuit board 14. The contact pads 48 are made of a conductive material, such as a suitable metal, for example copper. Vias 50 are located at the centers of the contact pads 48. The vias 50 are filled with conductive material, such as suitable metal, and provide electrical communication with layers of circuits (not shown) within the circuit board 14, not on the surface of the circuit board 14.

The contact pads 48 are located on individual circuit board fingers 54 of circuit board material, with rectangular slots 58 between adjacent contact pads 48 (between adjacent fingers 54). The slots 58 are configured to receive the ribs 40 when the connector 10 is coupled to the circuit board 14, as is described further below. The contact pads 48 are located away from the circuit board edge 12, such that there are distal portions (free ends) of the fingers 54 onto which the contact pads 48 do not extend. There are also proximal portions of the fingers 54 near the bases of the fingers 54 onto which the contact pads 48 do not extend. The slots 58 thus have a depth that extends beyond the locations of the contact pads 48.

Fig. 4 shows the connector 10 coupled to the circuit board 14. As the connector 10 is engaged with the circuit board 14 the tails 42 align with the contact pads 48. The tails 42 may be permanently attached to the contact pads 48, such as by soldering.

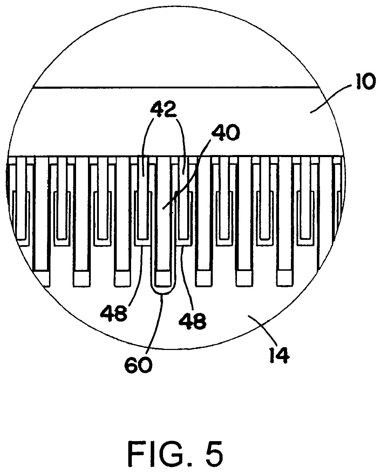

In addition the ribs 40 enter into the slots 58 as the connector 10 is engaged with the circuit board 14. The ribs 40 are located between adjacent combinations of the tails 42 and the contact pads 48. The ribs 40 provide improved electrical isolation between the pad-tail combinations, blocking the shortest gap between adjacent tails 42 and adjacent contact pads 48. The height of the ribs 40 (the extent in the direction orthogonal to the surface of the circuit board 14) considerably lengthens the isolation path above and below the ribs 40. Fig. 5 shows the shortest current isolation path, a path 60 around the distal end (free end) of the ribs 40, near the bottom of the slots 58. The combination of ribs 40 and the slots 58 thus provides an extended isolation path that prevents current leakage and voltage breakdown.

Many variants are possible regarding the above device and method. For example device may include any suitable number of contacts, as well as various configurations for the contacts.

Although the invention has been shown and described with respect to a certain preferred embodiment or embodiments, it is obvious that equivalent alterations and modifications will occur to others skilled in the art upon the reading and understanding of this specification and the annexed drawings. In particular regard to the various functions performed by the above described elements (components, assemblies, devices, compositions, etc.), the terms (including a reference to a "means") used to describe such elements are intended to correspond, unless otherwise indicated, to any element which performs the specified function of the described element (i.e., that is functionally equivalent), even though not structurally equivalent to the disclosed structure which performs the function in the herein illustrated exemplary embodiment or embodiments of the invention. In addition, while a particular feature of the invention may have been described above with respect to only one or more of several illustrated embodiments, such feature may be combined with one or more other features of the other embodiments, as may be desired and advantageous for any given or particular application.

## Claims

1. A device comprising:
a circuit board (14) with individual circuit board fingers and slots (58) between adjacent individual circuit board fingers (54), wherein the circuit board has contact pads (48) located on the individual circuit board fingers (54) of the circuit board (14), such that there are distal and proximal portions of the circuit board fingers (54) onto which the contact pads (48) do not extend, wherein each individual circuit board finger has a respective contact pad located between a distal portion and a proximal portion of an individual circuit board finger; and
a connector comprising ribs (40) alternating with contact tails (42), the connector being configured to engage the circuit board (14) such that each of the contact tails (42) engages a respective one of the contact pads (20, 22) and each of the ribs (40) enters into a respective slot (58) between adjacent circuit board fingers (54).

2. The device of claim 1, wherein the slots (58) are rectangular slots.

3. The device of claim 1, wherein the slots (58) have a depth that extends further from an edge (12) than do the contact pads.

4. The device of claim 1, wherein the ribs (40) are between adjacent contact pads (48), extending the isolation path between the adjacent contact pads (48).

5. The device of claim 1, wherein the ribs (40) are parts of a plastic connector body of the connector (10).

6. The device of claim 5, wherein the connector body is a single molded plastic piece.

7. The device of claim 1, wherein the contact pads have respective conductive vias that electrically connect the conductive pads (48) to circuitry of the circuit board (14).

8. The device of claim 7, wherein the circuitry is within the circuit board (14), as opposed to being on a surface of the circuit board (14).

9. The device of any of preceding claims, wherein the combination of the ribs (40) and the slots (58) provides an extended isolation path preventing current leakage and voltage breakdown.

## Patentansprüche

1. Vorrichtung, umfassend:
eine Leiterplatte (14) mit einzelnen Leiterplattenfingern und Schlitzen (25) zwischen angrenzenden einzelnen Leiterplattenfingern (54), wobei die Leiterplatte auf den einzelnen Leiterplattenfingern (54) der Leiterplatte (14) befindliche Kontaktflächen (48) aufweist, sodass dort distale und proximale Bereiche der Leiterplattenfinger (54) sind, auf die sich die Kontaktflächen (48) nicht erstrecken, wobei jeder einzelne Leiterplattenfinger eine jeweilige Kontaktfläche zwischen einem distalen Bereich und einem proximalen Bereich eines einzelnen Leiterplattenfingers aufweist; und
einen Verbinder, umfassend sich mit Kontaktenden (42) abwechselnden Lamellen (40), wobei der Verbinder zum Eingreifen in die Leiterplatte (14) ausgebildet ist, sodass jedes der Kontaktenden (42) in jeweils eine der Kontaktflächen (20, 22) eingreift und jede der Lamellen (40) in einen jeweiligen Schlitz (58) zwischen angrenzenden Leiterplattenfingern (54) eintritt.

2. Vorrichtung nach Anspruch 1, wobei die Schlitze (58) rechteckige Schlitze sind.

3. Vorrichtung nach Anspruch 1, wobei die Schlitze (58) eine Tiefe aufweisen, die sich weiter als die Kontaktflächen von einem Eck (12) erstreckt.

4. Vorrichtung nach Anspruch 1, wobei die Lamellen (40) zwischen angrenzenden Kontaktflächen (48) sind, den Isolationspfad zwischen den angrenzenden Kontaktflächen (48) erweiternd.

5. Vorrichtung nach Anspruch 1, wobei die Lamellen (40) Teile von einem Plastikverbindungskörper des Verbinders (10) sind.

6. Vorrichtung nach Anspruch 5, wobei der Verbindungskörper ein einzeln geformtes Pastikstück ist.

7. Vorrichtung nach Anspruch 1, wobei die Kontaktflächen jeweilige leitende Durchkontaktierungen aufweisen, die die leitenden Flächen (48) zu einem Schaltkreis der Leiterplatte (14) elektrisch verbinden.

8. Vorrichtung nach Anspruch 7, wobei der Schaltkreis innerhalb der Leiterplatte (14) ist, anstatt auf einer Oberfläche der Leiterplatte (14) zu sein.

9. Vorrichtung nach einem der vorherigen Ansprüche, wobei die Kombination der Lamellen (40) und der Schlitze (58) einen verlängerten Isolationspad bereitstellt, der Ableitstrom und Spannungsabfall verhindert.

## Revendications

1. Dispositif comprenant :
une carte de circuits imprimés (14) avec des doigts individuels de carte de circuits imprimés et des fentes (58) entre des doigts (54) individuels adjacents de carte de circuits imprimés, dans lequel la carte de circuits imprimés a des plots (48) de contact situés sur les doigts (54) individuels de carte de circuits imprimés de la carte de circuits imprimés (14), de telle manière qu'il y a des parties distale et proximale des doigts (54) de carte de circuits imprimés sur lesquelles les plots (48) de contact ne s'étendent pas, dans lequel chaque doigt individuel de carte de circuits imprimés a un plot de contact respectif situé entre une partie distale et une partie proximale d'un doigt individuel de carte de circuits imprimés ; et
un connecteur comprenant des nervures (40) alternées avec des talons (42) de contact, le connecteur étant configuré pour engager la carte de circuits imprimés (14) de telle manière que chacun des talons (42) de contact engage un respectif des plots (20, 22) de contact et que chacune des nervures (40) pénètre dans une fente (58) respective entre des doigts (54) adjacents de carte de circuits imprimés.

2. Dispositif selon la revendication 1, dans lequel les fentes (58) sont des fentes rectangulaires.

3. Dispositif selon la revendication 1, dans lequel les fentes (58) ont une profondeur qui s'étend plus loin d'un bord (12) que ne le font les plots de contact.

4. Dispositif selon la revendication 1, dans lequel les nervures (40) sont entre des plots (48) de contact adjacents, étendant le chemin d'isolation entre les plots (48) de contact adjacents.

5. Dispositif selon la revendication 1, dans lequel les nervures (40) sont des parties d'un corps de connecteur en plastique du connecteur (10).

6. Dispositif selon la revendication 5, dans lequel le corps de connecteur est une pièce unique en plastique moulé.

7. Dispositif selon la revendication 1, dans lequel les plots de contact ont des trous de raccordement conducteurs respectifs qui connectent électriquement les plots (48) conducteurs à un ensemble de circuits de la carte de circuits imprimés (14).

8. Dispositif selon la revendication 7, dans lequel l'ensemble de circuits est à l'intérieur de la carte de circuits imprimés (14), comme opposé à être sur une surface de la carte de circuits imprimés (14).

9. Dispositif selon l'une quelconque des revendications précédentes, dans lequel la combinaison des nervures (40) et des fentes (58) offre un chemin d'isolation étendu empêchant une fuite de courant et un claquage en tension.
